# EUROPEAN PATENT SPECIFICATION

(11) **EP 3 336 495 B1**
(45) Date of publication and mention of the grant of the patent: **14.02.2024**
(21) Application number: 16204804.5
(22) Date of filing: 16.12.2016
(51) Int. Cl.: G01J 1/42, G01J 1/04, G02B 21/00, G02B 21/26, G02B 13/00, G01N 21/64, G01N 21/53, G01N 21/47, G02B 5/00

(54) **CHARACTERIZING THE EMISSION PROPERTIES OF SAMPLES**
CHARAKTERISIERUNG DER EMISSIONSEIGENSCHAFTEN VON PROBEN
CARACTÉRISATION DES PROPRIÉTÉS D'ÉMISSION D'ÉCHANTILLONS

(43) Date of publication of application: 20.06.2018
(73) Proprietor: F. Hoffmann-La Roche AG, 4070 Basel (CH); Roche Diagnostics GmbH, 68305 Mannheim (DE)
(72) Inventor: WIETZORREK, Joachim, 6300 Zug (CH)
(74) Representative: Peterreins Schley

(56) References cited:
- WO-A1-2015/200315
- WO-A1-2016/070155
- WO-A2-2007/044725
- WO-A2-2008/025958
- CN-A- 106 018 286
- CN-A- 106 023 082
- JP-A- H0 574 687
- Popp Alois K. ET AL: "Light-scattering microscope as a tool to investigate scattering heterogeneity in tissue", Proceedings of SPIE, vol. 3917, 19 April 2000 (2000-04-19), pages 22-32, XP055853879, 1000 20th St. Bellingham WA 98225-6705 USA ISSN: 0277-786X, DOI: 10.1117/12.382746 ISBN: 978-1-5106-4548-6
- M. Levoy ET AL: "Recording and controlling the 4D light field in a microscope using microlens arrays", Journal of Microscopy, vol. 235, no. 2, 1 August 2009 (2009-08-01), pages 144-162, XP055522739, GB ISSN: 0022-2720, DOI: 10.1111/j.1365-2818.2009.03195.x

## Description

### Technical Field

This disclosure relates to methods for characterizing light sources and samples, and to devices and analyzers for characterizing light sources and samples.

### Background

The task of characterizing the emission characteristics of a light emitting sample plays an important role in many fields. For example, it might be desirable to characterize a light source to be deployed in an automated analyzer for samples (e.g., an in-vitro analyzer). This characterization can include detecting the angular emission pattern of the light source, as well as the spatial distribution of the light emission over the light source's surface. One known technique to characterize a light source in this manner is the goniometric approach. In a goniometer, a detector is moved about the light source to be characterized and captures light emitted from the light source in different directions. In some examples, spatially resolved images are taken at each angular position by a matrix detector. This technique is called near-field goniometry (the light source to be characterized is not considered as a point source). Goniometers can require fairly bulky and complex mechanical arrangements. Therefore, some of these devices can be comparatively large and expensive.

### Summary

A first general aspect of the present disclosure relates to a method for characterizing a light source, the method including providing a light source to be characterized, collecting light emitted from the light source by using imaging optics, the imaging optics generating a pupil of the collected light emitted from the light source, generating an image of a pupil of light emitted only from a first surface area of the light source at a detector using the imaging optics, laterally shifting the light source and the imaging optics relative to each other and after the lateral shift, generating an image of a pupil of light emitted only from a second surface area of the light source at the detector using the imaging optics, wherein the imaging optics includes a field stop between the light source and the detector to select a portion of the light source's surface from which light is imaged at a time.

In a second general aspect of the present disclosure, a device for characterizing a light source is configured to perform the operations of the method of the first general aspect of the present disclosure.

In a third general aspect of the present disclosure, a method of analyzing a sample in an analyzer for samples includes collecting light emitted from the sample by using imaging optics, the imaging optics being further configured to generate a pupil of the collected light emitted from the sample and generating an image of the pupil of the sample at a matrix detector using the imaging optics, so that rays having different angular directions when emanating from the sample are imaged onto different locations at the matrix detector.

In a fourth general aspect of the present disclosure, an analyzer for analyzing sample is configured to carry out the operations according to the third general aspect of the present disclosure.

The methods of the first and third general aspects and the devices of the second and fourth general aspects can have one of more of the following advantages in some embodiments.

Firstly, by employing pupil imaging techniques to characterize light sources or samples (e.g., samples in an in-vitro analyzer), the techniques of the present disclosure can provide a relatively cost efficient way to characterize the spatial and angular emission properties of light sources or samples.

Some prior art characterization techniques to characterize the spatial and angular emission properties of light sources or samples use goniometric techniques. These techniques can require relatively large and expensive devices for moving a matrix detector about a light source or sample to be characterized.

For carrying out the techniques of the present disclosure, on the other hand, only relatively simple mechanical components might be required in some examples. For instance, a translational actuator to move a light source or a sample in two translational dimensions might be sufficient. In other examples, the techniques of the present disclosure can characterize an extended light emitting sample spatially and angularly without moving parts. In this manner, the setups required to carry out the techniques of the present disclosure might be more compact and cost-efficient than some prior art solutions in some situations.

Secondly, the pupil imaging techniques of the present disclosure can be employed in analyzers, e.g., in vitro analyzers for analyzing samples. Here, the techniques of the present disclosure can be used to characterize the angular emission properties of samples (e.g., of a liquid analyte). This can provide additional information regarding the sample to be analyzed compared to some known solutions.

For example, in an in vitro analyzer operating in transmission employing the techniques of the present disclosure, the angular emission characteristics of a sample can be measured. In contrast to that, some known analyzers only obtain a single transmission value / absorption value for a sample at a given wavelength. The additional information obtained when using the techniques of the present disclosure can be useful to deduce different properties of the sample. Thirdly, the pupil imaging systems of the present disclosure can be integrated relatively easily in common analyzer setups in some situations. For example, some analyzers use a microscope-type setup to characterize the optical properties of a sample (e.g., the absorption of a sample). It might be difficult to integrate a goniometric set-up in these systems without considerable design changes.

The systems of the present disclosure, on the other hand, can be realized in a microscope set-up (or other known analyzer setups) without a significant number of changes to the arrangement of the components in some examples. As a consequence, the systems of the present disclosure can be integrated in existing analyzers without requiring a substantial redesign of the analyzer. In this manner, the systems of the present disclosure might be employed in existing analyzer setups without adding excessively to the complexity and thus the cost of the system.

After having provided an overview over the techniques of the present disclosure, in the following paragraphs several terms will be discussed which are used in the present disclosure in a particular manner.

The term 'light' is used in the present disclosure as not limited to radiation in the visible wavelength range (e.g., between 400 nm and 780 nm). Rather, light can also include radiation in the IR- or UV-range. For example, light can include radiation in a wavelength range between 150 nm and 2000 nm (e.g., between 250 nm and 1600 nm).

In the present disclosure the expressions `light emitted from a surface / surface area' does not mean that the light generation process actually takes place at the respective surface or surface area. Rather, the expression `emitted from' indicates that the light exits the surface at the respective position. The term 'emanating from' is used in the same sense.

The term 'optics' is used in the present disclosure to refer to any assembly of one or more optical elements arranged to perform a particular task. For example, optics can include a plurality of lens elements arranged to steer light from an input plane to an output plane. In addition, optics can include further elements to filter or shape the light traversing the optics.

For example, optics can include field stops or aperture stops, or wavelength selective filters. The elements of the optics can also be (at least partially) integrated in some examples.

The term `imaging optics' is used in the present disclosure to refer to any optics which substantially preserves the order of a set of rays propagating through the optics. For example, imaging optics can be configured to create an image of a field or a pupil of an object. Thus, imaging optics are not limited to assemblies configured to generate an image of an object. Rather, and imaging optics can also be configured to generate an image of a pupil of an object (i.e. a defocused image of the field of the object), or a partially defocused image.

The term 'pupil' is used in the present disclosure as referring to an image of an aperture of a system. In other words, in the pupil rays propagating at a predetermined angle to a central axis of the optical system meet at the same point. For example, in the pupil of light emanating from a light-emitting surface, all rays exiting the light-emitting surface under a certain angle meet at the same point. Thus, each position in the pupil represents all the rays exiting the surface under the particular angle. Sharp points of the light-emitting surface are defocused in the pupil (and vice-versa). The pupil and images of the light-emitting surface are optically conjugated.

Depending on the layout of the optical system, there can be multiple replicas of the pupil along the optical path. In other words, a pupil formed by the optics can be imaged to a plane further downs the optical path (and this can happen multiple times in some systems).

The pupil does not have to coincide with an element of the imaging optics.

The terms 'analyzer' / 'analytical work cell' / 'analytical unit' as used herein encompass any apparatus or apparatus component that can measure analytical properties of a sample, e.g., following a reaction of a sample with a reagent for obtaining a measurement value.

An analyzer can be operable to determine one or more parameters of a sample or a component thereof. For example, a parameter can be an absorption, transmittance or reflectance of the sample contained in a cuvette or other sample vessel. In other examples, a parameter can be a fluorescence of a sample after having been illuminated with excitation light. Apart from the optical measurement devices of an analyzer discussed below (e.g., to determine an absorption, transmittance or reflectance), an analyzer can include measurement devices to determine a parameter of the sample via one or more chemical, biological, physical, or other technical procedures.

An analyzer may be operable to determine said parameter of the sample or of at least one analyte, process the determined parameter and return an obtained measurement value. The list of possible analysis results returned by the analyzer comprises, without limitation, concentrations of the analyte in the sample, a qualitative (yes or no) result indicating the existence of the analyte in the sample (corresponding to a concentration above the detection level), optical parameters, DNA or RNA sequences, data obtained from mass spectroscopy of proteins or metabolites and physical or chemical parameters of various types.

An analytical work cell may comprise units for pipetting, dosing, and mixing of samples and/or reagents. The analyzer may comprise a reagent holding unit for holding reagents to perform the assays. Reagents may be arranged for example in the form of containers or cassettes containing individual reagents or group of reagents, placed in appropriate receptacles or positions within a storage compartment or conveyor. It may comprise a consumable feeding unit. The analyzer may comprise a process and detection system whose workflow is optimized for certain types of analysis. Examples of such analyzers are clinical chemistry analyzers, coagulation chemistry analyzers, immunochemistry analyzers, urine analyzers, hematology analyzers, nucleic acid analyzers, used to detect the result of chemical or biological reactions or to monitor the progress of chemical or biological reactions.

The term 'sample' refers to material(s) that may potentially contain an analyte of interest. In some examples, the sample can be a liquid sample. The sample can be derived from a biological source, such as a physiological fluid, including blood, saliva, ocular lens fluid, cerebrospinal fluid, sweat, urine, stool, semen, milk, ascites fluid, mucous, synovial fluid, peritoneal fluid, amniotic fluid, tissue, cultured cells, or the like. The biological sample can be pretreated prior to use, such as preparing plasma from blood. Methods of treatment can involve centrifugation, filtration, distillation, dilution, concentration and/or separation of sample components including analytes of interest, inactivation of interfering components, and the addition of reagents. A sample may be used directly as obtained from the source or used following a pretreatment to modify the character of the sample. In some embodiments, an initially solid or semi-solid biological material can be rendered liquid by dissolving or suspending it with a suitable liquid medium. In some examples, the sample can be suspected to contain a certain antigen or nucleic acid.

Unless specified otherwise, the term 'substantially' in the present disclosure refers to a deviation of +/- 10% from a predetermined value. For example, if the length of two elements is substantially equal, they are actual length can differ by up to 10%. In the same manner, if an intensity distribution is substantially homogeneous, deviations from up to 10% from an average value might occur.

### Description of the Drawings

**FIG. 1** shows an example characterization system for characterizing a light source according to the present disclosure.
**FIG. 2** shows a portion of a characterization system for characterizing a light source according to the present disclosure including a second arm for adjustment purposes.
**FIG. 3** illustrates an example characterization system for characterizing light sources according to the present disclosure including a first measurement arm and a second adjustment arm.
**FIG. 4** shows an example pupil image generated by the techniques of the present disclosure, and an image of a surface of a light-emitting device reconstructed based on the pupil image.
**FIG. 5** depicts an example characterization system for a sample according to the present disclosure.
**FIG. 6a** shows example rays emanating from the surface of the sample.
**FIG. 6b** depicts example rays focused by a field lens array according to the present disclosure.

### Detailed Description

Particular aspects of the methods for characterizing light sources and samples, and of the devices and analyzers for characterizing light sources and other samples according to the present disclosure will be discussed subsequently.

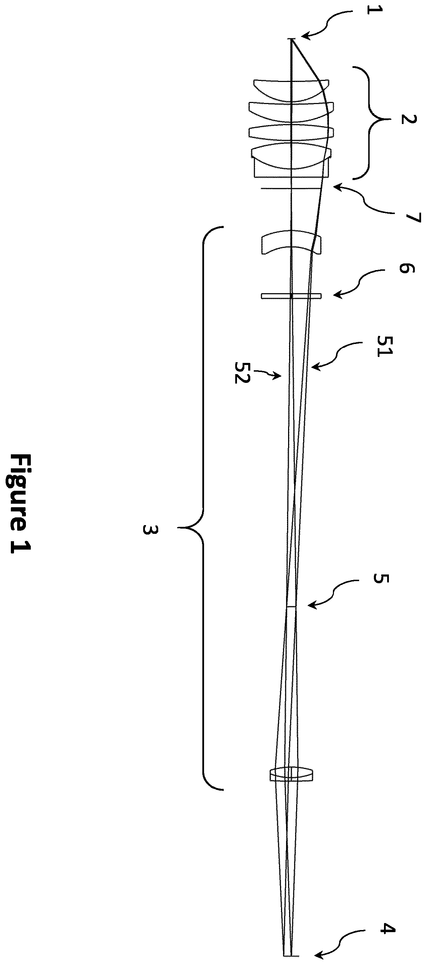

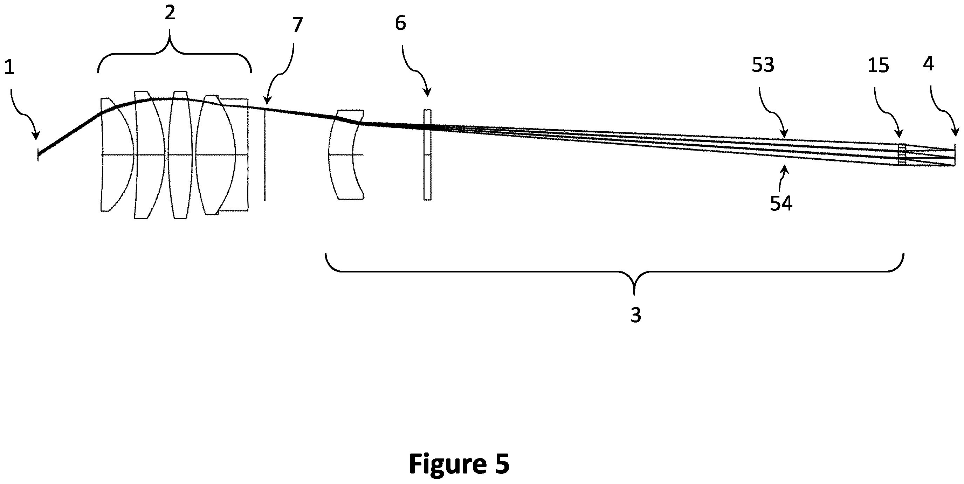

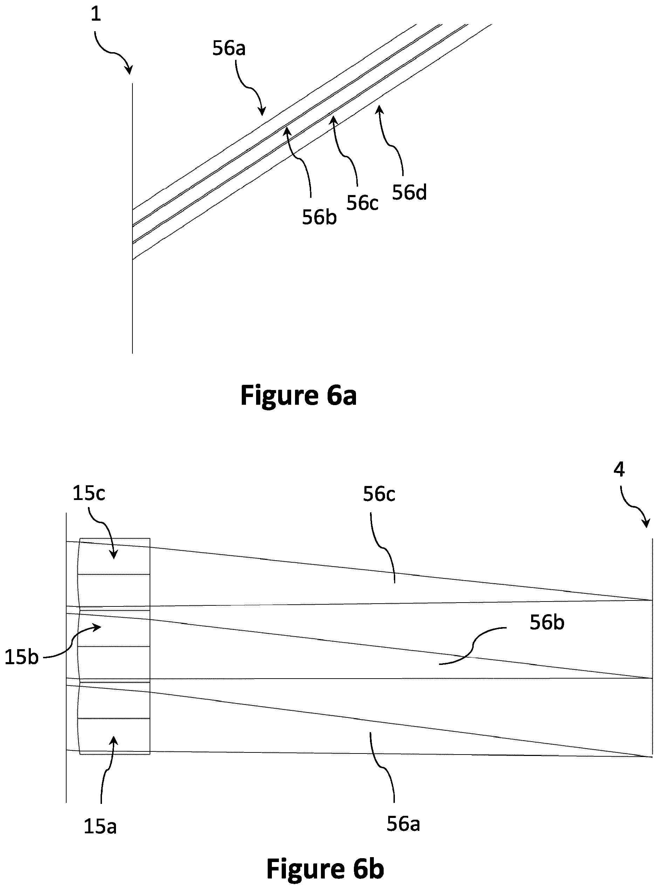

The detailed description is split into two main parts. First, in connection with **FIGS. 1 to 3****,** aspects of characterization devices and methods to characterize the emission properties of a light source will be explained. Said devices and methods do not fall under the scope of the claims. Subsequently, in connection with **FIG. 5** and **FIG. 6a** and **FIG. 6b**, aspects of the analyzers falling under the scope of claim 1 and corresponding methods for characterizing a sample according to the present disclosure will be discussed. It should be pointed out that the techniques for characterizing a light source and the techniques for characterizing a sample discussed herein deploy the same underlying principle of pupil imaging. Therefore, aspects discussed herein in connection with the devices and methods for characterizing a light source can also be deployed in the devices and methods for characterizing a sample discussed herein, and vice versa (unless the particular aspect is incompatible with the peculiarities of the respective device or method).

Having said this, **FIG. 1** shows an example device for characterizing a light source, the device including a support 1 for receiving a light source to be characterized, a detector 4, imaging optics 2, 3 and a translation actuator (not shown in **FIG. 1****).**

The imaging optics 2, 3 is configured to collect light emitted from the light source, to generate a pupil 7 of the collected light emitted from the light source and to generate an image of a pupil of light emitted only from a particular surface area of the light source at the detector 4. The translation actuator is configured to laterally shift the support 1 and the imaging optics 2, 3 relative to each other.

The system further includes a controller (not shown in **FIG. 1**) configured to laterally shift the support 1 and the imaging optics 2, 3 relative to each other and to control the detector 4 to generate an image of a pupil of light emanating only from a particular surface area of the light source at the detector 4.

The imaging optics 2, 3 includes a field stop 5 between the support for receiving a light source 1 and the detector 4 to select a portion of the light source's surface from which light is imaged at a time.

In the following sections, the operation of the system of **FIG. 1** will be explained. Subsequently, the different element of the device for characterizing a light source and their possible configuration will be discussed in more detail.

As can be seen in **FIG. 1**, light is emanating from a light source arranged in the support 1 in different angular directions. **FIG. 1** shows two example groups of rays emanating from the light source's surface. A first group of rays 52 travels substantially along a main axis of the imaging optics 2, 3 (in an orthogonal direction relative to the surface of the light source). A second group of rays 51 exits the surface of the light source under an angle.

In the example of **FIG. 1**, the angle of the second group of rays 51 is a maximum angle that can still be captured by the imaging optics 2, 3. In other words, the angle of the second group of rays 51 corresponds to the input numerical aperture of the imaging optics 2, 3.

Even though it cannot be clearly seen on the left hand side in **FIG. 1**, each of the first and second group of rays 51, 52 includes a plurality of rays emanating from the surface of the light source (e.g., being slightly displaced in a transversal direction). The reason for that is that the light source is spatially extended, so that light exits the light source's surface at different positions. This situation is illustrated in **FIG. 6a** which shows an enlarged view of a group of rays exiting the surface of a light emitting sample. This can also be seen when following the path of the rays further down the imaging optics 2, 3 to the region between the pupil 7 and the field stop 5. Each of the first and second group of rays 51, 52 includes rays emanating from different spatial positions on the light source's surface which therefore propagate under different angles between the pupil 7 and the field stop 5.

Now, the imaging optics generates a pupil 7 of the collected light emanating from the light source. As can be seen, the first group of rays 52 traverses the pupil 7 in a central position. All the rays of their first group of rays meet at the same position in the pupil 7. Likewise, the rays of the second group of rays 51 meet in the pupil 7 at a different spatial position. As the second group of rays 51 corresponds to rays propagating under the maximum angle that can be collected by the imaging optics 2, 3, the position is a most outward position in the pupil 7. Even though only two group of rays 51, 52 are shown in **FIG. 1** for the sake of illustration, it can easily be seen that groups of rays exiting the surface of the light source under different angles than the first and second groups of rays 51, 52 (i.e., under intermediate angles) are likewise being imaged onto the pupil 7 at different spatial positions. All the rays collected from the light source light source traverse the pupil 7, wherein a spatial position in the pupil 7 correspondence to a particular angular direction of the respective rate when exiting the surface of the light source.

This pupil 7 is subsequently imaged onto the detector 4 by the imaging optics 2, 3 of the system of **FIG. 1**. Therefore, the spatial position of a ray on the detector 4 also corresponds to a particular angle under which the rays exit the surface of the light emitting device. In other words, the rays are 'sorted' according to their emission angle at the detector 4.

However, the pupil 7 in **FIG. 1** constitutes an average pupil averaged over the complete surface of the light emitting device from which light can be collected by the imaging optics 2, 3. Thus, the imaging optics 2, 3 additionally includes the field stop 5 configured to restrict the area of the light-emitting devices surface which is imaged at a time. This will be explained more detail next.

As can be seen in **FIG. 1**, the field stop 5 is located in an intermediate field plane of the imaging optics 2, 3. Thus, at the position of the field stop 5, an image of the surface of the light emitting device located in the support 1 is formed. By selecting a portion of this image, only rays emanating from this particular portion of the surface of the light-emitting device are imaged onto the detector 4. The rays emanating from other surface areas are blocked by the field stop 5.

The size of the area of the surface imaged at the time can be selected by selecting the size of the field stop 5. In this manner, the device of **FIG. 1** generates a local or spatially resolved pupil image of the particular surface area of the light emitting device (instead of an average pupil image over the complete surface area from which light can be collected which would be generated if the field stop 5 was not present).

In order to generate a spatially resolved image of the light emitting devices surface, the imaging optics 2, 3 and the support 1 for the light-emitting device are translated relative to each other. For example, after generating a pupil image of a first surface area of the light-emitting device, the translation actuator can change the relative position of the support 1 and the imaging optics 2, 3. In this manner, the field stop 5 selects a second, different portion of the surface area of the light-emitting device. Then, an image of this second surface area of the light emitting device can be generated on the detector 4.

This procedure can be repeated multiple times. In this fashion, the complete surface of the light-emitting device, or a particular fraction of the surface of the light-emitting device can be imaged in at step like manner.

In some examples, a surface area scanned in the above described manner can be (much) larger than a field of view of the imaging optics 2, 3. In this manner, extended light sources (e.g., arrays of multiple LEDs) can be analyzed. However, in other examples the surface area scanned can be smaller than a field of view of the imaging optics 2, 3.

The resulting data can constitute a complete characterization of the spatial and angular emission characteristics of the light source (at least of the portion of the emission characteristics which can be collected by the imaging optics 2, 3 due to the limited numerical aperture of the imaging optics 2, 3). As a consequence, the spatial and angular emission characteristics of the light source can be reconstructed from the serious of images taken by the system of **FIG. 1**.

It has been explained above that the dimension of the field stop 5 determines the size of the surface area whose light reaches the detector 4 at a time. Accordingly, the translation of the imaging optics 2, 3 relative to the support can be selected to cover the complete surface area. In some examples, the field stop 5 can be larger so that light from a larger surface of the light source reaches the detector 4. In other cases, the field stop 5 can be smaller so that light from a smaller surface of the light source reaches the detector 4. Accordingly, a length of a step of the translation can be larger or smaller, respectively. In other words, the size of the field stop can determine a resolution of the characterization process of the light source and the stepping motion.

In some examples, the detector 4 can register intensity data of the rays of light in the pupil images (e.g., a photon count at each position of the detector). This intensity data can be an indicative of an intensity of the light exiting the light sources surface under the respective angle at the particular portion of the light source's surface. The intensity data can be added to the data set characterizing the light source's emission pattern.

Thus, the resulting dataset can be resolved in two spatial dimensions over the surface of the light source, two angular dimensions and can additionally include intensity data. In other words, the system of **FIG. 1** can generate a five dimensional dataset characterizing the emission properties of the light source. As explained above, this is possible by only effecting a relative translation of the support 1 and the imaging optics 2, 3 in two linear directions. In particular, no rotating movement of the detector about the light source to be analyzed might be necessary (such as in goniometric setups).

However, in some examples the light source to be characterized can be moved in additional directions. For example, the light source could be turned (e.g., in a step-wise manner) in some examples.

In addition, depending on an extension of the light source, the traveling path of the translation movements can be relatively low. Therefore, characterizing the emission properties of a light source by using the system of **FIG. 1** can be relatively cost and space efficient in some examples.

After the general operation principle of the system of **FIG. 1** has been explained in the preceding sections, the different components of the system of **FIG. 1** will be discussed in more detail subsequently.

As can be seen, the imaging optics 2, 3 of **FIG. 1** includes a first optics assembly 2 and a second optics assembly 3. The first optics assembly 2 is configured to collect light emanating from the light source arranged in the support 1. Moreover, the first optics assembly 2 is configured to generate the pupil 7 of the collected light in its back focal plane. In one example, the first optics assembly to can be a collector (e.g. a collector of a microscope set up).

An input numerical aperture of the first optics assembly 2 (e.g., the collector) can limit the range of angles of rays the characterization device of **FIG. 1** can detect (at least without rotating the sample).

As can be seen, the first optics assembly 2 includes a plurality of optical components (e.g., five lens elements in the example of **FIG. 1**)**.** However, any optics assembly suitable to collect light from the light source and to generate a pupil of the light collected from the light emitting device can be used. For example, the first optics assembly 2 might only include a smaller number of lens elements (e.g. one or two lens elements) in some examples, or different lens elements than the lens elements shown in **FIG. 1**. It might be necessary to include a plurality of optical components to meet particular design criteria depending on the circumstances (e.g., to provide a predetermined level of correction of imaging errors and/or to provide are predetermined numerical aperture or field of view of the imaging system or to meet a price criterion). Therefore, the setup of the first optical assembly 2 can be fairly different in other examples using the techniques of the present disclosure.

In general, the first optics assembly 2 can be sine corrected. In this manner, a distance of a particular ray of the center of the pupil 7 can be directly associated with the angle under which the respective ray exits the surface of the light source (e.g., the distance can be proportional to the cosine of the angle). Without the sine correction, there might be deviations from this direct correspondence which can make the pupil images more difficult to interpret. In addition to the first optics assembly 2, the imaging optics 2, 3 includes a second optical assembly 3 which is arranged to relay the pupil 7 onto the detector plane of the detector 4. In other words, the pupil 7 is replicated on the detector 4 by the second optical assembly 3. In one example, the second optical assembly 3 can be a tube lens.

It can be seen in **FIG. 1** that the second optical assembly 3 includes three lens elements (i.e., a meniscus lens and a doublet). Again, the concrete implementation of the second optical assembly 3 might be different and other examples of the present disclosure.

In other examples, the imaging optics can include further optical assemblies which generate further replicas of the pupil. For example, in a different example of imaging optics according to the present disclosure, there can be an intermediate replica of the pupil between the pupil and the image of the pupil captured by the detector.

In still other examples, the detector might be arranged at the first pupil generated by the imaging optics (e.g., at the position of pupil 7 in **FIG. 1**). In this example, the field stop 5 could be arranged between the pupil 7 and the surface of the light source (e.g., adjacent to the light source).

The detector 4 is a matrix detector configured to capture a spatially resolved image. For example, the detector for can be a CMOS or CCD detector. However, all other matrix detectors can also be used. In some examples, which do not fall under the scope of the claims, the detector 4 can also be a single pixel detector which is scanned to collect rays at different spatial positions in the detector plane.

As explained above, the device of **FIG. 1** also includes a wavelength selective filter 6 arranged in the second optics assembly 3. This wavelength selective filter 6 can be selected to only let pass a particular portion of the spectral band of the light exiting the light source. This can reduce chromatic effects due to rays at different wavelength being imaged to different spatial positions at the detector, even though these rays emanate from the surface of the light-emitting device under identical angles (and vice versa). This might happen due to chromatic aberrations of the imaging system and might impair the characterization capabilities of the system.

In other examples, the wavelength selective filter can be located at different positions of the device (e.g., at a different position in the imaging optics 2, 3). For examples, a wavelength selective filter can be arranged at or near the detector 4. In still other examples, there might not be a wavelength selective filter in device.

In some examples, the system can be configured to include filters with different pass bands to sequentially capture images in different wavelength bands. In this manner, the characterization of the light source can also be resolved wavelength-wise. For example, the filter 6 might be a tunable filter or can include a set of different filters that can be selectively moved into the optical path (e.g., a set of different filters in a filter wheel). In some examples, the controller of the imaging system might be configured to automatically tune the wavelength characteristics of the tunable filter 6.

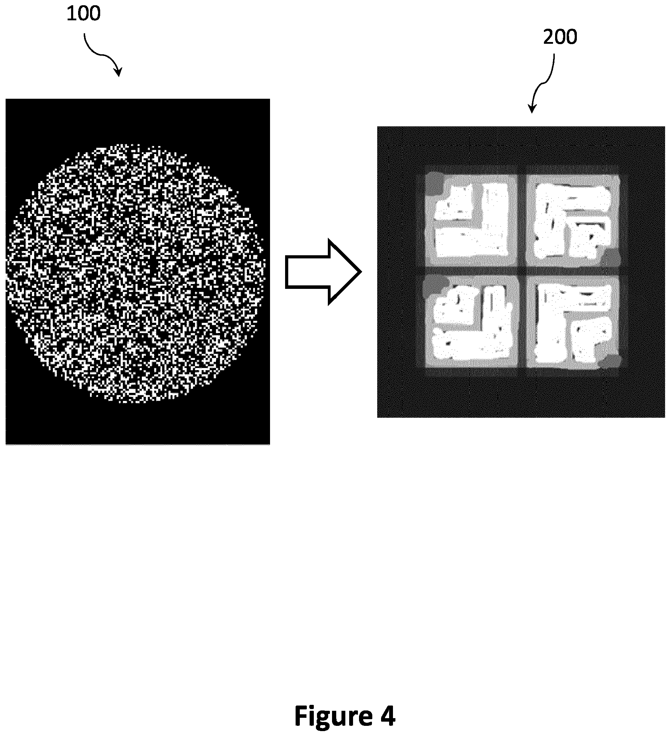

It has been explained above how a pupil of the light source's light collected by the imaging optics is generated. An example pupil image which can be generated by using the techniques of the present disclosure is shown in **FIG. 4**. The pupil image 100 is depicted on the left-hand side of **FIG. 4**. As can be seen, the pupil image 100 shows that a different number of rays exits the surface of the light-emitting device under different angles. For instance, a region in a central position of the pupil image 100 can represent light exiting the light source's surface in a perpendicular direction. In the same manner, a region in a fringe position of the pupil image 100 can represent light exiting the light source's surface under an angle corresponding to the input numerical aperture of the imaging optics.

As **FIG. 4** only includes a black and white drawing, the intensity information which might be present in the pupil image 100 is not visible in **FIG. 4**. It can be seen that each pixel of the pupil image 100 can carry intensity information.

As explained above, the characterization device of the present disclosure can capture a series of pupil images similar to pupil image 100 associated with different surface areas of the light emitting device. This set of pupil images can then be used to characterize the emission characteristics of the light source. For example, is possible to generate a map of the emission intensity of the light source over the surface of the light source. Such map 200 is shown on the right-hand side of **FIG. 4**. As can be seen, the example light source includes four LEDs arranged in a square array.

However, the dataset obtained by the system of the present disclosure also includes the angular characteristics of the emission of the light source. Therefore, spatially resolved images such as image 200 could also be generated for any other direction under which the characterised light source is observed.

In addition or alternatively, the data generated by the system of the present disclosure could also be processed into many different other representations. For example, an emission pattern at an arbitrary spaced-apart position from the light-source can be determined. As already explained, the emission data can be limited to a particular cone corresponding to the input numerical aperture of the imaging optics.

In still other examples, a different representation of the light source's emission characteristics based on the multiple images of pupils of light emitted from multiple surface areas specifying spatial and angular emission characteristics of the light source can be generated. For example, the representation does not have to be a graphical representation in some examples. For instance, a representation can include a textual or numeric presentation of ray data or other data representing the light source's emission characteristics (e.g., in form of a list or in form of a table). For example, a representation can specify a plurality of rays (e.g., an origin, angles of propagation and an intensity value for each ray) in text form.

In the examples above a light source including a plurality of LEDs has been discussed for the sake of illustration. However, the characterization device of the present disclosure can be used to any suitable other light source.

For example, the light source can include only a single LED. In other examples, the light source can include two or more, five or more or ten or more LEDs (which can be arranged in a two-dimensional array or in a linear configuration).

In still other examples, the light source can include one or more other types of light emitting elements than LEDs. For instance, the light source can include one or more semiconductor light emitting elements other than LEDs. In still other examples, the light source can include one or more gas-discharge light emitting elements (e.g., high-pressure or low-pressure discharge light emitting elements). In still other embodiments, the light source can include one or more glow-discharge light emitting elements.

Moreover, the light source can include one or more components arranged between a location of the light source where light is (initially) generated and a surface or surface area of the light source where light exits the light source, possibly after wavelength conversion, (also called "secondary light source") to be characterized with the techniques of the present disclosure.

The one or more components can include passive components. For instance, the one or more components can include components to steer light (e.g., by refraction, reflection or elastic scattering).

In one example, the one or more component can be an elastic scattering element or a lens element. In this example, the techniques of the present disclosure can be used to characterize output light at the surface of the elastic scattering element or lens element.

In another example, the light source can include a homogenizer (e.g., a mining rod) which provides homogenized light at an output surface.

In still other examples, the one or more components can include a non-elastically scattering component (e.g., a component containing a phosphor). In this example, the surface of the light source can be formed (at least partially) by the non-elastically scattering component.

As can be seen from these examples, the light source to be characterized can be an assembly of light-emitting and light-steering or light-converting elements. In any case, the surface (or a portion of the surface) of the assembly from which light exits into the environment can be characterized by the techniques of the present disclosure.

Different examples of the actuator effecting the relative translation of the support and the imaging optics will be discussed next. It has been discussed above that the actuator is configured to effect the relative movement of the support 1 and the imaging optics 2, 3 to allow for capturing different surface areas of a light source to be characterized.

In one example, the support 1 is coupled to the translation actuator. In this example, laterally shifting can include keeping the imaging optics 2, 3 stationary while the support 1 (and with it the light source) is laterally shifted. In other examples, the imaging optics 2, 3 is coupled to the translation actuator. In this example, laterally shifting can include keeping the support 1 (and with it the light source) stationary while laterally shifting the imaging optics 2, 3. In still other examples, the translation actuator can be configured to laterally translate both the support 1 and the imaging optics 2, 3 to effect a relative translation.

In any case, the translation actuator can include any actuator suitable to effect a one-dimensional or two-dimensional translation of the respective component coupled to the actuator. For example, the translation actuator can include a linear electric motor. However, in other examples the translation actuator might be a pneumatic or hydraulic actuator.

In some examples, translation in two orthogonal directions might be necessary to scan a complete surface of the light source. However, in other examples, the translation actuator might only be configured to translate the support 1 and the imaging optics 2, 3 relative to each other in one direction or one dimension.

As discussed above, the translation activator might be controlled by a controller of the characterization device. The controller might be programmable so that the translation actuator scans through a predetermined pattern to image different portions of the surface of the light source automatically. In addition alternatively, the image generation process might also be automatized. In this manner the characterization system of **FIG. 1** might be adapted to automatically perform a characterization measurements of a light source.

As can be seen in **FIG. 1**, the relative translation can happen in a direction which is orthogonal to the main axis of the optical system. In a conventional microscope set-up, the translation directions might be referred to as x-direction and y-direction (the third direction being the z-direction).

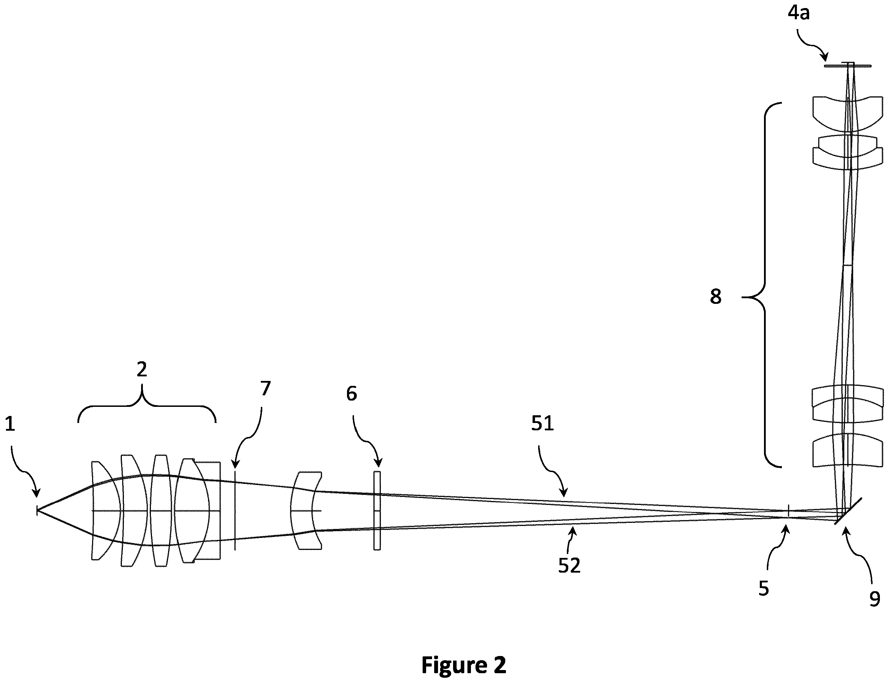

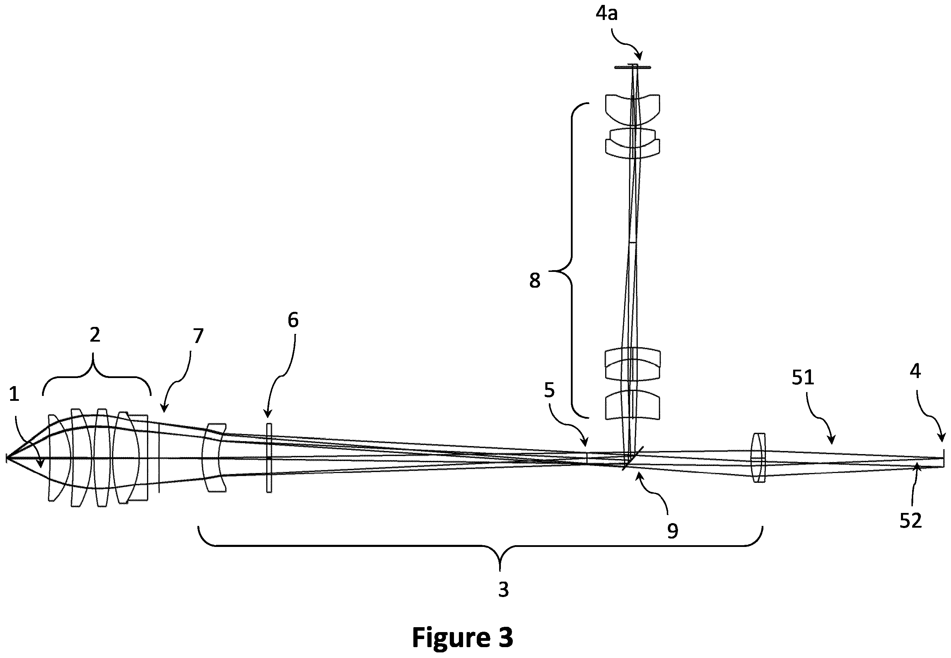

After the main components of the system of **FIG. 1** have been explained above, in the subsequent sections several additional components the characterization device might contain in some examples will be discussed next in connection with **FIG. 2** and **FIG. 3**.

**FIG. 2** shows a portion of an example characterizing system according to the present disclosure. As can be seen, the system includes a folding mirror 9 arranged in the light path of the imaging optics. In some examples, the folding mirror can be a semi-transparent mirror which only reflects a portion of the light traversing the imaging optics. In other examples, the folding mirror 9 can be arranged in a removable manner (e.g., it can be pivoted into and out of the optical path). In these examples, the folding mirror 9 can be inserted in the light path (e.g. for adjustment purposes) and then removed again.

The characterization system of **FIG. 2** additional includes a third optics assembly 8. The third optics assembly 8 is configured to generate an image of the surface of the light source to be characterized on a second detector 4a. In this manner, the imaging system provides the capability to directly inspect an image of the light source to the characterized. This can be helpful for adjusting the light source's position before starting capturing the pupil images. For instance, a starting point of the scanning motion over the surface of the light source can be selected at a predetermined position (e.g. in the center of the surface of the light source or at the corner of the surface of the light source).

The second detector can include a matrix detector (e.g., a CCD or CMOS detector).

A complete set-up of a characterization system including a first arm including the detector 4 for capturing pupil images of a surface of a light source to be characterized and a second arm including the detector 4a for capturing an image of the surface of a light source to be characterized (e.g. for adjustment purposes) is shown in **FIG. 3**.

As can be seen, the pupil imaging path is arranged in a first arm of the imaging device or is the field imaging path is arranged in a second arm of the characterization device. The light propagating in the imaging optics is split between the two paths by a semitransparent mirror 9 arranged in the light path. In other examples, an arrangement of the two arms can be reversed. As also shown in **FIG. 3**, the first and second arms share several optical components. In other examples the first and second arms can have separate optical components.

In the preceding sections, techniques to characterize the emission properties of a light source have been discussed. Similar techniques can also be used to characterize the emission properties of a sample in a sample analyzer (e.g. an in-vitro analyzer for analyzing samples). Different aspects of this application of the techniques of the present disclosure will be discussed subsequently in connection with **FIG. 5****.**

**FIG. 5** shows an analyzer for analyzing a sample including a sample support 1 for receiving a sample to be analyzed, a matrix detector 4 and imaging optics 2, 3.The imaging optics 2, 3 is configured to collect light emitted from the sample, generate a pupil 7 of the collected light emitted from the sample and generate an image of the pupil of the sample at a matrix detector 4, so that rays having different angular directions when emanating from the sample are imaged onto different locations at the matrix detector 4.

As can be seen, the analyzer of **FIG. 5** has certain similarities to the characterization system of **FIG. 1**. In particular, the imaging optics 2, 3 is set up in a similar manner. The only difference being that instead of the second lens element of the second optics assembly and the field stop shown in **FIG. 1** the analyzer of **FIG. 5** includes a field lens array 15. This field lens array 15 is arranged in a field plane of the imaging optics 2, 3. Accordingly, the propagation of the rays of light emanating from the sample surface is similar to the propagation of the light of the light source in the device of **FIG. 1** until the rays reach the field plane of the second optics assembly 3.

As explained above, in the field plane an image of the surface of the sample to be analyzed is formed. Therefore, light emanating from different surface areas of the sample impinges on different lens elements of the field lens array 15. As also shown in **FIG. 5****,** each lens element of the field lens array 15 focuses light onto a different spatial area of the matrix detector 4. In other words, the field lens array 15 is designed so that images of pupils of different surface areas of the sample are imaged onto separate areas of the detector. These different images do not overlap. As a consequence, this set up of **FIG. 5** can capture pupil images of a plurality of separate surface areas of the sample at one time.

Additional explanations regarding the operation principle of the analyzer of **FIG. 5** will now be given in connection with **FIG. 6**a and **FIG. 6b**.

**FIG. 6**a is an enlarged view of the sample surface to be characterized. As can be seen, a group of parallel rays of light 56a, 56b, 56c, 56d emanate from the sample surface. As these rays of light 56a, 56b, 56c, 56d propagate under the same angle (e.g., compared to the main axis, they will traverse the same spatial position in the pupil 7 (see **FIG. 5**).

As now can be seen in **FIG. 6b**, the different rays hit different lens elements 15a, 15b, 15c of the field lens array. These different lens elements are arranged and selected so that an image generated on the detector plane does not overlap with images generated by other lens elements 15a, 15b, 15c.

Going back to **FIG. 5**, the imaging optics 2, 3 is configured to guide rays propagating from the surface of the sample under different angles than the example rays 53, 54 in the same manner as the example rays 53, 54. In particular, rays propagating from a particular surface area of the sample will be guided towards the same lens element of the field lens array 15 (since the field lens array 15 is arranged in a field plane of the imaging optics).

In this manner, each lens element of the field lens array 15 will generate a pupil image of a particular surface area of the sample under investigation. Therefore, the analyzer of **FIG. 5** can process a plurality of sample positions in parallel.

In the example of **FIG. 5**, the field lens array 15 is shown including a number of lens elements. It should be pointed out that **FIG. 5** only shows a section through the field lens array which can include a two dimensional array of lens elements.

In other examples, a different component including two or more optical elements than a field lens array can be arranged between the sample and the detector so that each of the two or more optical elements is configured to generate an image of a pupil of light emitted from a different surface area of the sample on the detector and that the images of pupils of light emitted from the different surface areas of the sample on the detector do not overlap. Moreover, a number of lens elements in the field lens array 15 (or optical elements in a different component) can be different in different examples. The number of lens elements shown in **FIG. 5** is for illustrative purposes only. Similar as in the device of **FIG. 1**, a size of each lens element can be selected to determine a spatial resolution of the pupil images of the sample. For instance, if smaller lens elements are deployed, each partial pupil image on the detector can include rays emanating from a smaller surface area of the sample.

The different areas of the sample imaged in parallel by the analyzer of **FIG. 5** can belong to the same sample (e.g., an analyte in a cuvette or other sample receptacle) or, as defined in claim 1, to different samples.

For example, the different areas might be associated with different sample positions of a multi-vessel sample holder of the analyzer. In one example, the sample support 1 supports a sample holder having a plurality of receptacles for receiving a plurality of samples. For instance, the sample support 1 might be configured to hold a plurality of cuvettes, a multiwell plate, a plurality of test tubes or a plurality of other vessels to hold samples. Then, the analyzer of **FIG. 5** can simultaneously image the pupils of light emanating from each (or a subset of) this plurality of samples (e.g., a plurality of wells of a multiwell plate).

One example analyzer according to the present disclosure includes a plurality of cuvettes which are to be measured in transmission. In this system, the device of **FIG. 5** can be employed to perform a parallel measurement of the scattering properties of samples in each of the plurality of cuvettes.

The analyzer of **FIG. 5** can be any of the analyzers discussed in the summary section above. In accordance with the appended claims, the analyzer is an in vitro analyzer for analyzing biological samples, which is configured to perform turbidimetric measurements.

The analyzer can include additional components to the components discussed in connection with **FIG. 5****.** In general, the analyzer can be set up in different ways.

For example, the analyzer can include an illumination source for illuminating the sample. The light captured by the imaging optics 2, 3 shown in **FIG. 5** can be linearly or nonlinearly scattered light emanating from the sample in response to illumination by the illumination source (e.g., fluorescent or other luminescent light).

The illumination source can be arranged in different relationships compared to the imaging optics. In one example, which does not fall under the scope of the claims, the illumination source is arranged in an epi-illumination setup. In other words, the illumination light arrives at the same side of the sample at which the imaging optics 2, 3 is arranged. For example, the illumination source might illuminate the sample under an oblique angle. In other examples, the illumination light generated by the illumination source might be guided towards the sample via (at least some) of the optical components of the imaging optics 2, 3. For example, the first set of optical components 2 might also be arranged to focus illumination light onto the sample.

In examples falling under the scope of the claims, the illumination source is arranged in a trans-illumination setup. In other words, the illumination light arrives at the sample on a different side compared to the side were the imaging optics 2, 3 is arranged. For example, the illumination source is arranged to shine light through the sample which can then be collected by the imaging optics 2, 3.

As explained above, the system of **FIG. 5** can characterize the angle the characteristics of light emitted from the sample. In this manner, scattering characteristics of a sample can be obtained. This might be useful to draw conclusions regarding a composition of the sample. For example, a concentration of substances having particular scattering processes can be used. In some known analyzers, the angular properties of the light emanating from the sample might not have been resolvable. The light emanating in different direction has been integrated at the detector. The technique of the present disclosure provides additional information regarding the sample compared to these known analyzers.

In some examples, the analyzers of the present disclosure include (or are coupled to) a computing device which can derive a spatially resolved image of the sample, or draw conclusions regarding a composition of the sample based on the emission pattern data derive by employing the techniques of the present disclosure. According to claim 1, the computing device uses information regarding the scattering properties of a predetermined substance to infer a concentration of this substance using the information gathered by the techniques of the present disclosure.

In the example of **FIG. 5** a field lens array 15 is used to separate the pupil images of different areas of the sample to be analyzed. However, in other examples, other optical elements might be used to fulfill this task. In addition, in still other examples, the analyzer might be set up in a similar manner as the characterizing system for a light source of **FIG. 1**.

It can be seen that, in an example not falling under the scope of the claims, instead of generating the pupil images of different portions of the sample in parallel as in the system of **FIG. 5**, a sequential technique as employed in the system of **FIG. 1** could also be used. Therefore, even though in connection with **FIG. 1** only the characterization of light source is discussed, the techniques discussed can also be used to sequentially characterize a sample (e.g. in an automated sample analyzer for samples).

The techniques of the present disclosure involve method steps which can be executed by a computerized system (e.g., the relative movement of the sample and imaging optics or the capturing and processing of pupil images). The present disclosure also relates to a computer-readable medium having instructions stored thereon which when executed by a system make the system perform the operations according to the present disclosure. Furthermore, the present disclosure also relates to an electric signal carrying instructions which when executed by a system make the system perform the operations according to the present disclosure.

## Claims

1. An analyzer for analyzing samples comprising:
a sample support (1) for receiving samples to be analyzed;
a matrix detector (4); and
imaging optics (2, 3) configured to:
collect light emitted from the samples,
generate pupils (7) of the collected light emitted from the samples;
generating images of the pupils of the samples at the matrix detector (4), so that rays having different angular directions when emanating from the samples are imaged onto different locations at the matrix detector (4),
**characterized in that**
the analyzer is a turbidimetry in-vitro analyzer,
and that
the analyzer further comprises:
a computing device configured to use information regarding the scattering properties of a predetermined substance to infer a concentration of this substance in the samples using the information gathered by the matrix detector (4).

2. The device of claim 1, wherein the sample support is a multi-vessel sample holder and wherein the analyzer is configured to simultaneously image the pupils of light emanating from different sample positions of a plurality of samples deployed in the multi-vessel sample holder.

3. The device of claim 2, wherein the multi-vessel sample holder is a multiwell plate.

4. The device of any one of claims 2 to 3, wherein the multi-vessel sample holder is configured to hold a plurality of test tubes or cuvettes.

5. The device of claim 4, wherein the multi-vessel sample holder is configured to hold a plurality of cuvettes which are measured in transmission.

6. The device of any of the preceding claims 1 to 5, wherein the imaging optics (2, 3) includes a first optics assembly (2) configured to generate the pupils (7) of light emitted from the samples at its back focal plane, optionally wherein the first optics assembly (2) includes sine corrected optics.

7. The device of claim 6, wherein the imaging optics further include a second optics assembly (3) configured to relay the pupils of the light emitted from the samples onto the detector (4).

8. The device of any one of the preceding claims 1 to 7, wherein the imaging optics (2, 3) includes two or more optical elements (15, 15a-15c) between the sample and the matrix detector (4), wherein each of the two or more optical elements (15, 15a-15c) is configured to generate an image of a pupil of light emitted from a different sample position on the detector (4), optionally wherein the two or more optical elements (15, 15a-15c) are selected so that the images of pupils of light emitted from the different sample positions on the detector (4) do not overlap.

9. The device of claim 8, wherein the two or more optical elements (15, 15a-15c) are included in a field lens array.

10. The device of any one of the preceding claims 1 to 9,
wherein the detector (4) detecting the image of the pupil arranged in a first arm; and further comprising:
a second detector (4a) for detecting the image of surface areas of the samples to be characterized arranged in a second arm.

11. The characterization device of claim 10 wherein a mirror (9) is arranged to reflect light into the first or the second arm.

12. The characterization device of claims 10 or claim 11, wherein the first arm and the second arm share one or more optical components.

13. The device of any one of the preceding claims 1 to 12, further comprising:
a color filter (6) between the samples to be characterized and the detector to filter a particular part of a spectrum of the samples to be characterized.

## Patentansprüche

1. Analysegerät zum Analysieren von Proben, umfassend:
einen Probenträger (1) zur Aufnahme von zu analysierenden Proben;
einen Matrixdetektor (4); und
Abbildungsoptik (2, 3), die dafür ausgebildet ist:
das von den Proben emittierte Licht zu sammeln,
Pupillen (7) des von den Proben gesammelten, emittierten Lichts zu erzeugen;
Bilder von den Pupillen der Proben an dem Matrixdetektor (4) zu erzeugen, sodass Strahlen mit verschiedenen Winkelrichtungen beim Austreten aus den Proben auf verschiedenen Stellen an dem Matrixdetektor (4) abgebildet werden,
**dadurch gekennzeichnet, dass**
das Analysegerät ein In-vitro-Trübungsmessgerät ist,
und dass
das Analysegerät ferner Folgendes umfasst:
eine Rechenvorrichtung, die dafür ausgebildet ist, Informationen bezüglich der Streuungseigenschaften einer vorbestimmten Substanz zu nutzen, um unter Nutzung der von dem Matrixdetektor (4) erfassten Informationen eine Konzentration dieser Substanz in den Proben abzuleiten.

2. Vorrichtung nach Anspruch 1, wobei der Probenträger eine Mehrgefäßprobenhalterung ist und wobei das Analysegerät dafür ausgebildet ist, die Pupillen von Licht, das von verschiedenen Probenpositionen einer Vielzahl von Proben ausgeht, die in der Mehrgefäßprobenhalterung verteilt sind, gleichzeitig abzubilden.

3. Vorrichtung nach Anspruch 2, wobei die Mehrgefäßprobenhalterung eine Mikrotiterplatte ist.

4. Vorrichtung nach einem der Ansprüche 2 bis 3, wobei die Mehrgefäßprobenhalterung dafür ausgebildet ist, eine Vielzahl von Teströhrchen oder Küvetten zu halten.

5. Vorrichtung nach Anspruch 4, wobei die Mehrgefäßprobenhalterung dafür ausgebildet ist, eine Vielzahl von Küvetten zu halten, die in Transmission gemessen werden.

6. Vorrichtung nach einem der vorstehenden Ansprüche 1 bis 5, wobei die Abbildungsoptik (2, 3) eine erste Optikbaugruppe (2) einschließt, die dafür ausgebildet ist, die Pupillen (7) von Licht, das von den Proben emittiert wird, an ihrer Schnittweitenebene zu erzeugen, gegebenenfalls wobei die erste Optikbaugruppe (2) sinuskorrigierte Optik einschließt.

7. Vorrichtung nach Anspruch 6, wobei die Abbildungsoptik ferner eine zweite Optikbaugruppe (3) einschließt, die dafür ausgebildet ist, die Pupillen des von den Proben emittierten Lichts an den Detektor (4) weiterzuleiten.

8. Vorrichtung nach einem der vorstehenden Ansprüche 1 bis 7, wobei die Abbildungsoptik (2, 3) zwei oder mehr optische Elemente (15, 15a-15c) zwischen der Probe und dem Matrixdetektor (4) einschließt, wobei jedes von den zwei oder mehr optischen Elementen (15, 15a-15c) dafür ausgebildet ist, ein Bild von einer Pupille von Licht, das von einer anderen Probenposition emittiert wird, an dem Detektor (4) zu erzeugen, gegebenenfalls wobei die zwei oder mehr optischen Elemente (15, 15a-15c) so ausgewählt sind, dass sich die Bilder von Pupillen von Licht, das von den verschiedenen Probenpositionen emittiert wird, an dem Detektor (4) nicht überlagern.

9. Vorrichtung nach Anspruch 8, wobei die zwei oder mehr optischen Elemente (15, 15a-15c) in einer Feldlinsenanordnung enthalten sind.

10. Vorrichtung nach einem der vorstehenden Ansprüche 1 bis 9,
wobei der Detektor (4) zum Erfassen des Bildes der Pupille in einem ersten Arm angeordnet ist; und ferner umfassend:
einen zweiten Detektor (4a) zum Erfassen des Bildes von Oberflächenbereichen der zu charakterisierenden Proben, der in einem zweiten Arm angeordnet ist.

11. Charakterisierungsvorrichtung nach Anspruch 10, wobei ein Spiegel (9) so angeordnet ist, dass er Licht in den ersten oder den zweiten Arm reflektiert.

12. Charakterisierungsvorrichtung nach Anspruch 10 oder Anspruch 11, wobei sich der erste Arm und der zweite Arm eine oder mehrere optische Komponente(n) teilen.

13. Vorrichtung nach einem der vorstehenden Ansprüche 1 bis 12, ferner umfassend:
einen Farbfilter (6) zwischen den zu charakterisierenden Proben und dem Detektor zum Filtern eines bestimmten Teils eines Spektrums der zu charakterisierenden Proben.

## Revendications

1. Analyseur pour analyser des échantillons comprenant :
un support d'échantillons (1) pour recevoir des échantillons à analyser ;
un détecteur matriciel (4) ; et
des optiques d'imagerie (2, 3) configurées pour :
collecter la lumière émise des échantillons,
générer des pupilles (7) de la lumière émise des échantillons collectée ;
générer des images des pupilles des échantillons au niveau du détecteur matriciel (4), de sorte que les rayons ayant des directions angulaires différentes lorsqu'ils émanent des échantillons sont imagés sur différents emplacements au niveau du détecteur matriciel (4),
**caractérisé en ce que**
l'analyseur est un analyseur de turbidimétrie in vitro,
et **en ce que**
l'analyseur comprend en outre :
un dispositif informatique configuré pour utiliser les informations concernant les propriétés de diffusion d'une substance prédéterminée pour en déduire une concentration de cette substance dans les échantillons en utilisant les informations recueillies par le détecteur matriciel (4).

2. Dispositif selon la revendication 1, dans lequel le support d'échantillons est un porte-échantillons multi-récipients et dans lequel l'analyseur est configuré pour imager simultanément les pupilles de lumière émanant de différentes positions d'échantillons d'une pluralité d'échantillons déployés dans le porte-échantillons multi-récipients.

3. Dispositif selon la revendication 2, dans lequel le porte-échantillons multi-récipients est une plaque multi-puits.

4. Dispositif selon l'une quelconque des revendications 2 à 3, dans lequel le porte-échantillons multi-récipients est configuré pour contenir une pluralité de tubes à essai ou de cuvettes.

5. Dispositif selon la revendication 4, dans lequel le porte-échantillons multi-récipients est configuré pour contenir une pluralité de cuvettes qui sont mesurées en transmission.

6. Dispositif selon l'une quelconque des revendications 1 à 5 précédentes, dans lequel les optiques d'imagerie (2, 3) comprennent un premier ensemble d'optiques (2) configuré pour générer les pupilles (7) de la lumière émise des échantillons au niveau de son plan focal arrière, dans lequel éventuellement le premier ensemble d'optiques (2) comprend des optiques à sinus corrigé.

7. Dispositif selon la revendication 6, dans lequel les optiques d'imagerie comprennent en outre un second ensemble d'optiques (3) configuré pour relayer les pupilles de la lumière émise des échantillons sur le détecteur (4).

8. Dispositif selon l'une quelconque des revendications 1 à 7 précédentes, dans lequel les optiques d'imagerie (2, 3) comprennent deux éléments optiques ou plus (15, 15a-15c) entre l'échantillon et le détecteur matriciel (4), dans lequel chacun des deux éléments optiques ou plus (15, 15a-15c) est configuré pour générer une image d'une pupille de la lumière émise d'une position d'échantillon différente sur le détecteur (4), éventuellement dans lequel les deux éléments optiques ou plus (15, 15a-15c) sont sélectionnés de sorte que les images des pupilles de la lumière émise des différentes positions d'échantillons sur le détecteur (4) ne se chevauchent pas.

9. Dispositif selon la revendication 8, dans lequel les deux éléments optiques ou plus (15, 15a-15c) sont compris dans un réseau de lentilles de champ.

10. Dispositif selon l'une quelconque des revendications 1 à 9 précédentes,
dans lequel le détecteur (4) détectant l'image de la pupille est agencé dans un premier bras ; et comprenant en outre :
un second détecteur (4a) pour détecter l'image des surfaces des échantillons à caractériser agencé dans un second bras.

11. Dispositif de caractérisation selon la revendication 10 dans lequel un miroir (9) est agencé pour réfléchir la lumière dans le premier ou le second bras.

12. Dispositif de caractérisation selon la revendication 10 ou la revendication 11, dans lequel le premier bras et le second bras partagent un ou plusieurs composants optiques.

13. Dispositif selon l'une quelconque des revendications 1 à 12 précédentes, comprenant en outre :
un filtre coloré (6) entre les échantillons à caractériser et le détecteur pour filtrer une partie particulière d'un spectre des échantillons à caractériser.
